# EUROPEAN PATENT APPLICATION

(11) **EP 1 156 517 A1**
(43) Date of publication of application: **21.11.2001**
(21) Application number: 00962996.5
(22) Date of filing: 29.09.2000
(51) Int. Cl.: H01L 21/28, H01L 21/301, H01L 29/43, H01L 29/78

(54) **METHOD FOR FORMING TUNGSTEN SILICIDE FILM AND METHOD FOR FABRICATING METAL-INSULATOR-SEMICONDUCTOR TRANSISTOR**

(30) Priority: 30.09.1999 JP 27960999
(71) Applicant: Applied Materials, Inc., Santa Clara, California 95054 (US)
(72) Inventor: YAMAZAKI, Manabu, Narita-shi, Chiba 286-8516 (JP); MAEDA, Yuji, Narita-shi, Chiba 286-8516 (JP); KANEKO, Yasuyuki, Narita-shi, Chiba 286-8516 (JP); KAWAI, Ichiro, Narita-shi, Chiba 286-8516 (JP)
(74) Representative: Draper, Martyn John
(86) International application number: JP0006791
(87) International publication number: WO0124238

(57) **Abstract**

A method of forming a WSi film comprises the steps of: (1) forming a deposition film 6 having the hexagonal crystal phase, containing Si and W as main constitutive elements, in a chemical vapor deposition method using source gasses containing WF₆ and *Si*_{*2*}*H*_{*2*}*Cl*_{*2*}, and (2) annealing a substrate 2 provided with the deposition film 6 thereon in an ammonia atmosphere to form a WSi film. The step (2) can be replaced by a step (3) of forming the deposition film 6, containing Si and W as main constitutive elements, in a CVD method at a stage temperature of not less than 600°C using source gasses, WF₆ and *Si*_{*2*}*H*_{*2*}*Cl*_{*2*}. Since the value of x in the WSix film can be controlled to an appropriate value by the formation of the hexagonal phase or by the deposition at the high temperature, variation in the thickness of the WSi film is small between before and after the annealing step. This method is applicable to a method of fabricating a metal-insulator-semiconductor transistor.

## Description

### Technical Field

The present invention relates to a method of forming a tungsten silicide film, and a method of fabricating a metal-insulator-semiconductor type transistor.

### Background Art

With progress in scaling-down of semiconductor integrated circuits, there are increasing needs for decrease in resistance of gate electrodes of metal-oxide-semiconductor (MOS) type transistors. For this decrease in resistance, the polycide structure is employed for the gate electrodes. The polycide structure has a two-layer structure consisting of a polysilicon layer and a tungsten silicide (WSi) layer. The polysilicon layer is placed between a gate oxide film and the WSi layer in order to stabilize the threshold of the MOS transistor. The WSi layer is used for the purpose of decrease in resistance of the gate electrode.

There are a number of studies on the polycide gate electrodes. One of documents is as follows: for example, "Characterization of the Dopant Effect Dichlorosilane-Based Tungsten Silicide Deposition," Journal of Electrochemical Society, Vol. 144, No. 10, Oct. 1997.

### Disclosure of the Invention

The inventor found the following problem in the research on WSi films. The WSi film that is formed under reference conditions R familiar to the inventor is low in resistance, but demonstrates great variation in the thickness thereof between before and after annealing. When the variation in thickness is great, internal stress due to this thickness variation remains in the WSi film. What is needed is not only the property of low resistance of the WSi film to be applied to the fine MOS transistors but also the property of reduced thickness variation thereof.

It is an object of the present invention to provide a method of forming a tungsten silicide film that exhibits small variation in thickness between before and after a thermal treatment of the WSi film, and a method of fabricating a metal-insulator-semiconductor type transistor.

The inventor conducted researches for forming the WSi film having these properties. The inventor speculated that the thickness variation of a deposition WSi film was caused by absorption of silicon atoms into the WSi film from the underlying silicon layer. This absorption results in the increase of the WSi film and the decrease of the underlying silicon layer in thickness. In order to make this absorption small, it is preferable to control the composition of tungsten (W) to silicon (Si) in the WSi film to an adequate value in the deposition. It is, however, generally considered that a high ratio of tungsten to silicon is preferable for decrease in resistivity of the deposition WSi film. Therefore, the two requirements seem conflicting with each other.

Under the above research, the inventor further advanced the investigation. As a result, the inventor accomplished the invention comprising the following features.

By a method of forming a tungsten silicide film according to one aspect of the present invention, the tungsten silicide film can be formed on a silicon semiconductor region provided on a principal surface of a substrate. The method comprises the steps of: (1) forming a deposition film, containing silicon and tungsten as main constitutive elements and having the hexagonal crystal phase, in a chemical vapor deposition (CVD) method using WF₆ and *Si*_{*2*}*H*_{*2*}*Cl*_{*2*}; and (2) carrying out a thermal treatment for the substrate having the deposition film thereon in an ammonia atmosphere to form a tungsten silicide film.

When the deposition film does not have an amorphous phase but has a hexagonal phase, the film is formed in the Si composition defined by the hexagonal phase. The hexagonal phase film allows the decrease of the number of silicon atoms supplied from the underlying silicon semiconductor region during the thermal treatment, as compared to an amorphous phase film. Therefore, the thickness change is relieved between before and after the thermal treatment.

By a method of forming a tungsten silicide film according to another aspect of the present invention, the tungsten silicide film can be formed on a silicon semiconductor region provided on a principal surface of a substrate. The method comprises the steps of: (3) forming a deposition film, containing silicon and tungsten as main constitutive elements, at a stage temperature over 550°C in a chemical vapor deposition method using WF₆ and *Si*_{*2*}*H*_{*2*}*Cl*_{*2*}; and (4) carrying out a thermal treatment for the substrate having the deposition film thereon in an ammonia atmosphere to form a tungsten silicide film.

The deposition film is preferably formed at the stage temperature of not less than 600°C.

Since the deposition film is formed at the stage temperature as shown above, the deposition film does not have an amorphous phase but mainly contains the crystal phase represented by the composition of WSiₓ. In this WSiₓ crystal phase, the value of the "x" is approximately two. In the deposition film having this value of x, the number of Si atoms, absorbed from the underlying polysilicon layer during the thermal treatment in the ammonia atmosphere, is reduced. Namely, the thickness change is relieved between before and after the thermal treatment.

These aspects of the invention described above are applicable to methods of fabricating metal-insulator-semiconductor transistors.

A method of fabricating a metal-insulator-semiconductor transistor according to still another aspect of the present invention, comprises the steps of: (5) forming a gate insulator on a principal surface of a substrate, (6) forming a silicon film on the gate insulator, (7) providing a CVD chamber with the substrate having the silicon film thereon, (8) forming a deposition film, containing silicon and tungsten as main constitutive elements, at a stage temperature over 550°C in a CVD method using WF₆ and *Si*_{*2*}*H*_{*2*}*Cl*_{*2*}, (9) providing a thermal treatment chamber with the substrate having the deposition film thereon, (10) carrying out a thermal treatment to the deposition film in an ammonia atmosphere in the thermal treatment chamber to form a tungsten silicide film, and (11) forming a gate electrode from the silicon film and tungsten silicide film subjected to the thermal treatment.

The deposition film is preferably formed at the stage temperature of not less than 600°C.

The tungsten silicide film thus formed is applicable to polycide gate electrodes.

The features of the invention described below can be combined with the invention described above. It is also noted that the features of the invention described below can be combined with each other.

In the methods according to the present invention, the stage temperature can be not more than 800°C. In the temperature range over this temperature, it is difficult to implement the formation of films in the CVD method. However, high stage temperatures are effective to increase in grain sizes.

In the methods according to the present invention, the silicon semiconductor region can be treated with a solution containing hydrofluoric acid prior to the formation of the deposition film.

In the methods according to the present invention, the silicon semiconductor region means a region made of at least one of a polysilicon layer, an amorphous silicon layer, a single crystalline silicon region, and a silicon layer containing germanium. The silicon layer means at least one of the polysilicon layer, the amorphous silicon layer, the single crystalline silicon region, and the silicon layer containing germanium. The formation of the polysilicon layer also embraces a process of first forming an amorphous silicon layer and then forming the polysilicon layer through a thermal treatment.

Further, the thermal treatment in the ammonia atmosphere is carried out in a rapid thermal annealing apparatus. This thermal treatment can decrease the resistance of the tungsten silicide film more than that in an annealing furnace.

The silicon semiconductor region preferably contains at least one element of phosphorus and boron. This can also decrease the resistance of the tungsten silicide film, as well as the resistance of the silicon semiconductor region.

### Brief Description of the Drawings

The above object and other objects, features, and advantages of the present invention will become easily understood from the following description of preferred embodiments of the present invention with reference to the accompanying drawings, in which:
Fig. 1 is a diagram to show a CVD apparatus suitable for forming the tungsten silicide film;
Figs. 2A to 2C are views to show deposition procedures for forming the tungsten silicide film;
Fig. 3 is a view to show an RTP apparatus suitable for annealing the tungsten silicide film;
Fig. 4A is a spectrum to show X-ray diffraction patterns measured after the formation of the deposition film in the CVD method, and Fig. 4B is a spectrum to show X-ray diffraction patterns measured after the annealing of the deposited film;
Fig. 5 is a diagram to show resistivities of tungsten silicide films after the annealing;
Fig. 6 is a diagram to show compositions of tungsten silicide films as deposited;
Fig. 7 is a diagram to show variation in thickness of tungsten silicide films between before and after the annealing;
Fig. 8 is a drawing to show experiment data in conditions T2 and comparative data in the reference conditions R; and
Fig. 9 is a cross-sectional view of a semiconductor integrated circuit structure for describing a method of fabricating MIS transistors.

### Best Mode for Carrying out the Invention

The preferred embodiments of the present invention will be described below in detail with reference to the drawings. The same portions will be denoted by the same reference symbols and redundant description will be omitted if possible.

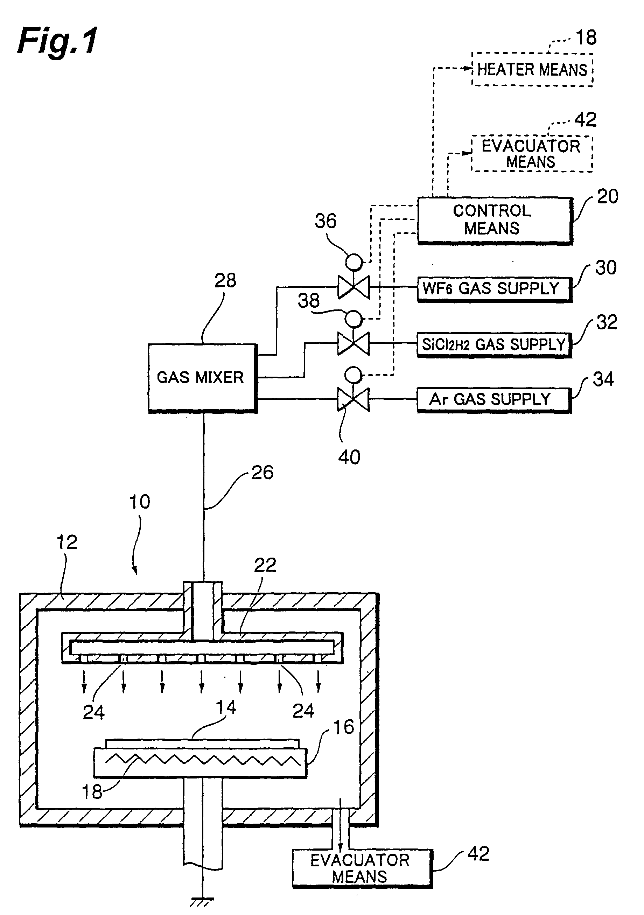

Fig. 1 shows a chemical vapor deposition (CVD) apparatus capable of carrying out a method of forming the tungsten silicide film according to the present embodiment. The CVD apparatus 10 is provided with a processing chamber 12 that can be depressurized to a desired vacuum degree. A substrate support means, e.g., pedestal 16, for supporting a substrate 14 to be processed such as a silicon wafer is provided in the processing chamber 12. The pedestal 16 is equipped with a heating means 18, such as a ceramic heater, for heating the silicon wafer 14. The heating means 18 is controlled by a control means 20, comprising a microcomputer, a memory, and so on, for controlling the entire apparatus. Thus, the heating means 18 controls the temperature of the pedestal 16, i.e., the stage temperature, so as to be kept at a temperature suitable for deposition. In this configuration, the heating means 18 can control the temperature of the substrate 14.

Inside the processing chamber 12, a gas distributing plate 22 is arranged opposite to the pedestal 16. The gas distributing plate 22 is placed in parallel to the pedestal 16 so as to uniformly supply gas toward the substrate 14. The gas distributing plate 22 is a hollow plate and is provided with a plurality of gas supply ports 24 in the surface facing to the pedestal 16. Predetermined process gas is supplied from a gas mixing chamber 28 outside the processing chamber through a pipe 26 into the interior space of the gas distributing plate 22. Source gases and carrier gas necessary for the deposition are uniformly mixed in the gas mixing chamber 28 preliminarily. In the present embodiment, the apparatus is provided with process gas supply means 30, 32, 24 to form the tungsten silicide film. The WF₆ gas supply means 30, SiCl₂H₂ gas (DCS gas) supply means 32, and Ar gas supply means 34 are connected via respective flow control valves 36, 38, 40 to the gas mixing chamber 28. Since the gas flow control valves 36, 38, 40 can be controlled by the control means 20, the flow rates of the respective gases are controlled in association with each other. The gas distributing plate 22 is made of an electroconductive material such as aluminum.

An evacuation means 42 such as a vacuum pump is connected to the processing chamber 12. By actuating the vacuum pump, it becomes feasible to evacuate the interior of the processing chamber 12 to a desired vacuum. The evacuation means 42 is also controlled by the control means 20.

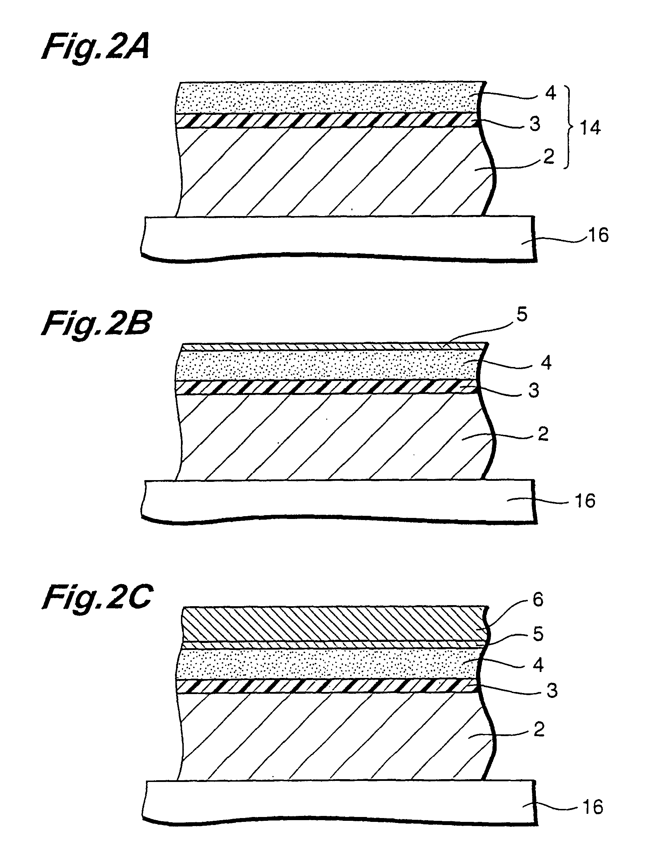

With reference to Fig. 1 and Fig. 2A to Fig. 2C, the procedures of forming a tungsten silicide film on the silicon semiconductor region by use of the CVD apparatus 10 will be described below. In the present patent application, the silicon semiconductor region means a polysilicon film, an amorphous silicon film, a polysilicon film made from an amorphous silicon film, or a single crystalline silicon region. The amorphous silicon film turns into the polysilicon film through the thermal treatment. The term "silicon semiconductor region" also embraces a silicon region containing germanium, i.e., SiGe.

A gate insulator film 3 is formed on the principal surface of the substrate 2 such as a silicon wafer. The gate insulator 3 is formed, for example, by thermally oxidizing the silicon substrate in a thermal oxidation method. Either of a polysilicon film and an amorphous silicon film can be deposited on the insulator 3, using a deposition apparatus such as the CVD apparatus. The description below concerns formation of the polysilicon film 4. The polysilicon film 4 can be doped with an n-type impurity such as phosphorus (P) during or after the deposition.

The substrate 14 has the insulator 3 and polysilicon film 4 thereon. Before loaded into the processing chamber 12, the substrate 14 is chemically treated with a solution containing hydrofluoric acid. This treatment removes native oxide from the surface of the polysilicon film 4. After this treatment, the substrate 14 is loaded into the CVD processing chamber 12 so as to be placed on the pedestal 16, as illustrated in Fig. 2A. The heating means 18 is regulated so as to maintain the stage temperature at 600°C.

First, a nucleation film is formed on the polysilicon film. The processing chamber 12 is depressurized to a predetermined vacuum, e.g., to 1.2 Torr. The source gases are SiCl₂H₂ *(DSC)* gas and WF₆ gas. The WF₆ gas supply 30, SiCl₂H₂ *(DSC)* gas supply 32, and Ar gas supply 34 provide the DSC gas, WF₆ gas, and Ar carrier gas to the gas mixing chamber 28 in response to regulation of the respective valves 36, 38, 49, respectively. In the present embodiment, a flow rate ratio of *DSC* gas/WF₆ gas is 25 and, specifically, *DSC*/WF₆ *=* 175 (sccm)/7 (sccm). The mixed process gas is introduced via the gas distributing plate 22 into the processing chamber 12. The process gas is adjusted in a gas composition suitable for deposition of silicon-rich WSix film. Under these conditions, the nucleation film 5 is deposited on the polysilicon film 4, as illustrated in Fig. 2B. In the present embodiment, the nucleation film 5 was grown to the thickness of 13 nm. The nucleation film 5 serves for nucleation of a subsequently grown film.

Next, a deposition film containing main components of tungsten and silicon is formed. For this step, the flow rate ratio of *DSC* gas/WF₆ gas is maintained at 18.4. The source gases of this flow rate ratio and the Ar carrier gas are supplied to the gas mixing chamber 28. The mixed gas is introduced through the gas distributing plate 22 into the processing chamber 12. Under such conditions, the deposition film 6 is formed on the nucleation film 5, as illustrated in Fig. 2C. In the present embodiment, the deposition film 6 was grown to the thickness of 87 nm.

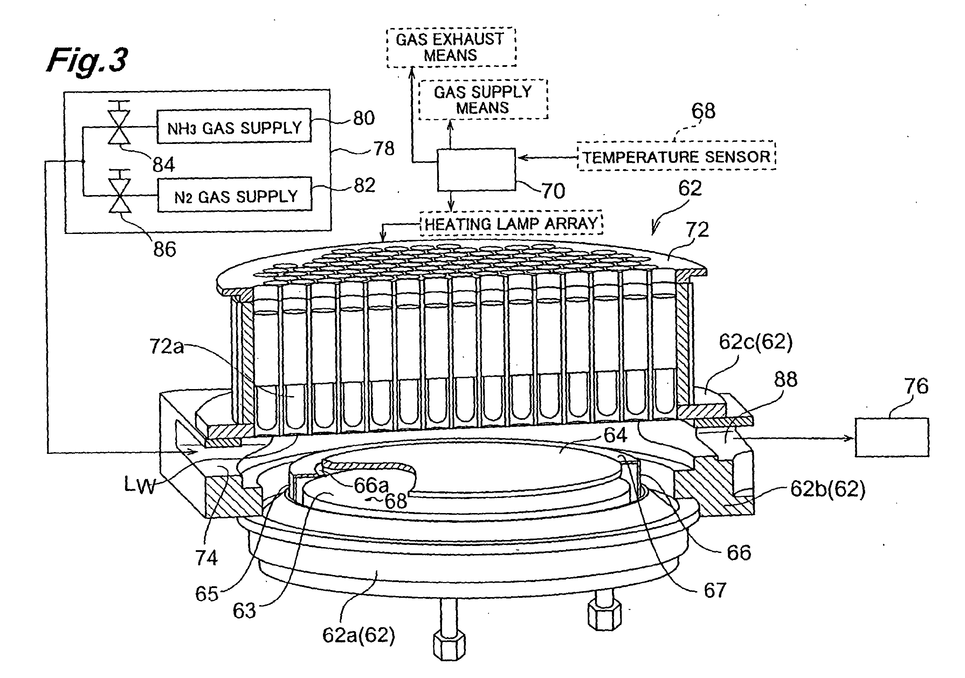

In a subsequent step, an annealing treatment is carried out to anneal the substrate having the nucleation film 5 and the deposited film 6 thereon. The annealing treatment is carried out in a thermal treatment apparatus in order to change the deposited film 6 into a thermally stabler phase. Fig. 3 schematically shows an RTP (Rapid Thermal Processing) apparatus. This RTP apparatus is suitable for carrying out the annealing treatment for formation of the tungsten silicide film according to the present embodiment.

The RTP apparatus 60 is provided with a processing chamber 62. The processing chamber 62 has a base portion 62a, a side wall portion 62b, and a lid portion 62c. A substrate support section 66 is provided in the processing chamber 62 so as to support a wafer (W) 64. The substrate support section 66 includes a cylinder frame 65 and a ring frame *65*. The cylinder frame 65 is mounted through a bearing on the base portion 62a. The ring frame 65 is arranged at the upper end of the cylinder frame 65. The ring frame *65* has a support step 66a supporting the edge of the wafer W at the inside edge of the frame 65. The wafer W is mounted so as to fit the support step 66a.

A heating lamp array 72 is located above the lid portion 62c. The heating lamp array 72 includes a plurality of heating lamps 72a for heating the wafer W placed on the substrate support section 66. The lid portion 62c is provided with lamp windows Lw at locations of the respective heating lamps 72a. Heat from the heating lamps 72a transfers through the lamp windows Lw onto the wafer surface. Temperature sensors 68 for optically detecting the temperature of the wafer W are provided on a circular plate 63 of the base portion 62a. In the drawing, only one temperature sensor 68 is depicted as an example. The temperature sensors 68 are able to send signals concerning the temperature to a control circuit 70 including a microcomputer and memory for controlling the entire apparatus. Each of the heating lamps 72a is controlled according to a signal from the control circuit 70 so as to keep the temperature constant on the surface of the substrate 64. This control makes it feasible to uniformly activate a deposited film on the substrate 64.

A gas inlet 74 and a gas outlet 88 are provided in the side wall portion 62b of the processing chamber 62. A gas supply means 78 is connected via flow control valves 84, 86 to the gas inlet 74. The gas supply means 78 includes an ammonia supply 80 and an N₂ supply 82. The ammonia supply 80 and N₂ supply 82 feed the process gases for the annealing to the processing chamber 62. A gas exhaust means 76 is connected to the gas outlet 88. The gas supply means 78 and the gas exhaust means 76 are controlled by the control circuit 70. In this apparatus, the controls such as the switching of the gases and the flow rate thereof are carried out in predetermined procedures.

Using this RTP apparatus, the substrate 64 having the deposited film 6 thereon is provided with the annealing treatment. Before the substrate 64 is loaded into the processing chamber 12, the surface of the substrate 64 is chemically treated with a surface treatment solution such as a hydrofluoric-acid-based solution. This treatment removes native oxide from the surface of the substrate 64. After this treatment, the substrate 64 is loaded into the processing chamber 62 so as to be placed on the pedestal 66.

The processing chamber 62 is depressurized to a predetermined vacuum, e.g., to 740 Torr. Only N₂ gas is first supplied as a process gas by regulating the valve 86. Then only NH₃ gas is supplied to the gas mixing chamber 78 by regulating the valve 84 of the NH₃ gas supply 80 and the valve 86 of the N₂ gas supply means 82. This process gas is introduced through a pipe 76 and via the gas inlet 74 into the processing chamber 62. This provides an ammonia atmosphere in the processing chamber 62. In the present embodiment, the flow rate of the NH₃ gas was set to 2 liters per minute.

Then the heating lamps 72 are turned on to quickly increase the temperature of the substrate 64 to 1000°C. The temperature of the substrate 64 is maintained at 1000°C for 30 seconds. Then, the heating lamps 72 are turned off to quickly decrease the temperature of the substrate 64. This completes the annealing. The temperature range of not less than 900°C and not more than 1100°C is also applicable to the annealing.

When the NH₃ gas is supplied during the annealing, a silicon nitride film is formed on the surface of the tungsten silicide film. This silicon nitride film is effective to protect the tungsten silicide film from chemical processing carried out in post-stages and is also effective as a barrier for preventing the dopant of phosphorus (P) and/or boron (B) in the polysilicon layer from migrating from the tungsten silicide film during the annealing. This can reduce impurities out-diffused from the tungsten silicide film. Therefore, the resistance of the tungsten silicide film is further decreased. In addition thereto, the silicon nitride film can also prevent the diffusion of the dopant (impurity) in the underlying polysilicon film. Therefore, this also results in the decrease in the resistance of the underlying polysilicon film.

Subsequently, the analyses on the characteristics of the tungsten silicide film as formed above will be described.

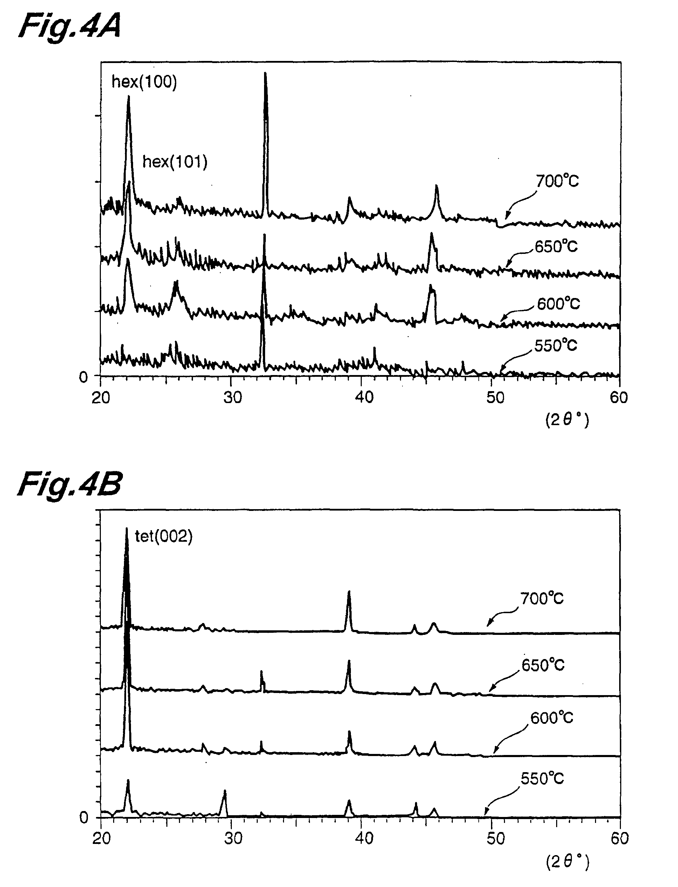

Fig. 4A is a spectrum showing X-ray diffraction patterns measured just after the deposition in the CVD method. The horizontal axis represents double diffraction angles θ, i.e., 2θ in units of degrees, and the vertical axis represents diffraction intensity in arbitrary units.

Referring to Fig. 4A, the peak corresponding to (100) of the hexagonal phase becomes prominent in the deposition at stage temperatures over 550°C, e.g., at 600°C,. This peak becomes larger as the stage temperature increases. This indicates that the hexagonal phase grows during the deposition. On the other hand, this peak is not prominent in the deposition at the stage temperature of 550°C.

Fig. 4B is a spectrum showing X-ray diffraction patterns measured after the annealing treatment of the tungsten silicide film. The horizontal axis represents double diffraction angles θ, i.e., 2θ in units of degrees, and the vertical axis represents diffraction intensity in arbitrary units.

Referring to Fig. 4B, the peak corresponding to (002) of the tetragonal phase becomes prominent in the deposition at stage temperatures over 550°C. This peak becomes larger as the stage temperature increases. This indicates that the tetragonal phase polycrystal is formed in the annealing. However, no specific peak appears prominent in the deposition at the stage temperature of 550°C.

Accordingly, it is seen from the X-ray diffraction data that the main crystalline phase in the tungsten silicide film as deposited is preferably the hexagonal phase when the tungsten silicide film is deposited in a CVD method.

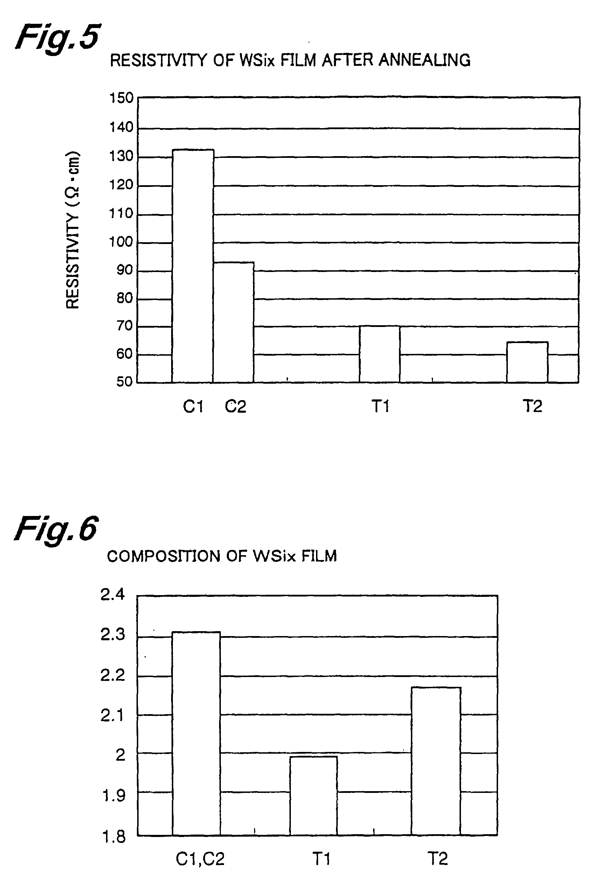

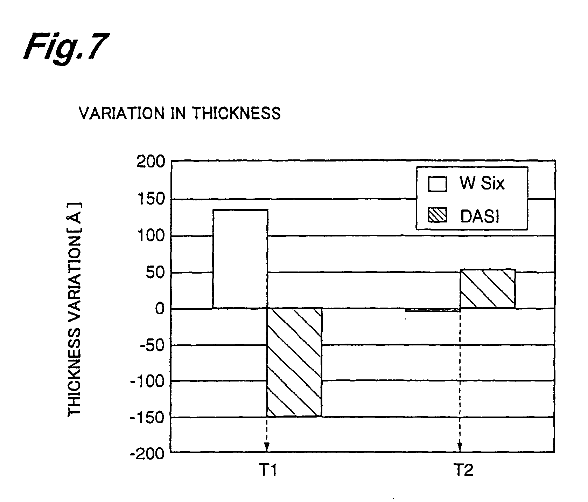

In addition to the data of X-ray diffraction patterns, further experiments were carried out as to the composition of the tungsten silicide film as deposited (see Fig. 5), the resistivity of the tungsten silicide film after the anneal (see Fig. 6), and the variation in the thickness of the tungsten silicide film between before and after the anneal (see Fig. 7).

The experiment data in the present application, together with the comparative data in the reference conditions R familiar to the inventor, is listed below. Conditions T2 correspond to the present embodiment.

| Conditions Flow rate Deposition Anneal Annealing | | | | |
|---|---|---|---|---|
| | ratio | temperature | method | temperature |
| C1 | 30.0 | 550°C | furnace | 850°C |
| C2 | 30.0 | 550°C | RTA | 1000°C |
| T1 | 18.4 | 550°C | RTN | 1000°C |
| T2 | 18.4 | 600°C | RTN | 1000°C |

Here, the flow rate ratio means a flow rate ratio of DSC gas/WF₆ gas. RTA indicates Rapid Thermal Annealing. RTN represents Rapid Thermal Nitridation. The annealing time under the conditions C1 is about 30 minutes and the annealing time is 30 seconds under the conditions C2, T1, and T2. Under the conditions C1, the annealing treatment was conducted at the temperature of 850°C in the N₂ atmosphere, and under the condition C2 the annealing treatment was conducted at the temperature of 1000°C in the N₂ atmosphere.

Fig. 5 shows the resistivities after the annealing. Samples used in this measurement exhibited the following resistivities:
Conditions C1: 132.5 *µ*Ω · cm
Conditions C2: 93.2 *µ*Ω · cm
Conditions T1: 69.3 *µ*Ω · cm
Conditions T2: 54.1 *µ*Ω · cm
Accordingly, the conditions T2 according to the present embodiment exhibit the lowest resistivity. With the value of resistivity accomplished in the conditions T2, the tungsten silicide film according to the present embodiment can be satisfactorily applied to semiconductor integrated circuits. The conditions C2, T1, and T2 demonstrate excellent properties as compared to the conditions C1. From this result, the annealing temperature is preferably not less than 1000°C.

Fig. 6 shows compositions of deposition films before the annealing treatment. In the conditions C1, C2 in which the flow rate ratios of the source gases are relatively large in the deposition, the Si/W ratio is over 2.3. On the other hand, in the conditions T1 in which the flow rate ratio is relatively small and the stage temperature is relatively low, the Si/W ratio is less than 2.0. In the conditions T2 according to the present embodiment, the Si/W ratio is approximately 2.2. As a consequence, it is preferable to set the flow rate ratio to be smaller than 39.0 and not less than 18.4 in order to accomplish the subject of the present application. The stage temperature is preferably higher than 550°C. The ratios in Fig. 6 were determined based on the measurement by RBS (Rutherford Back Scattering) spectroscopy.

Fig. 7 shows thickness differences of the tungsten silicide (WSix) film and the underlying polysilicon (DASi) film between before and after the annealing treatment for the conditions T1 and T2. The horizontal axis indicates each of the conditions and the vertical axis indicates change of thickness in units of nm. In each condition, the left part indicates the Wsix film and the right part indicates the DASi film. The negative sign indicates decrease of thickness. Concerning the thickness changes of the samples used in this measurement, under the conditions T1 the tungsten silicide film exhibits the thickness increase of about 15 nm (150Å) and the polysilicon film exhibits the thickness decrease of about 15 nm (150Å). Under the conditions T2, there is little change in the thickness of the tungsten silicide film, and the polysilicon film demonstrates the thickness increase of about 5 nm (50Å). Therefore, the conditions T2 according to the present embodiment provide the tungsten silicide film with the reduced thickness variation between before and after the annealing treatment.

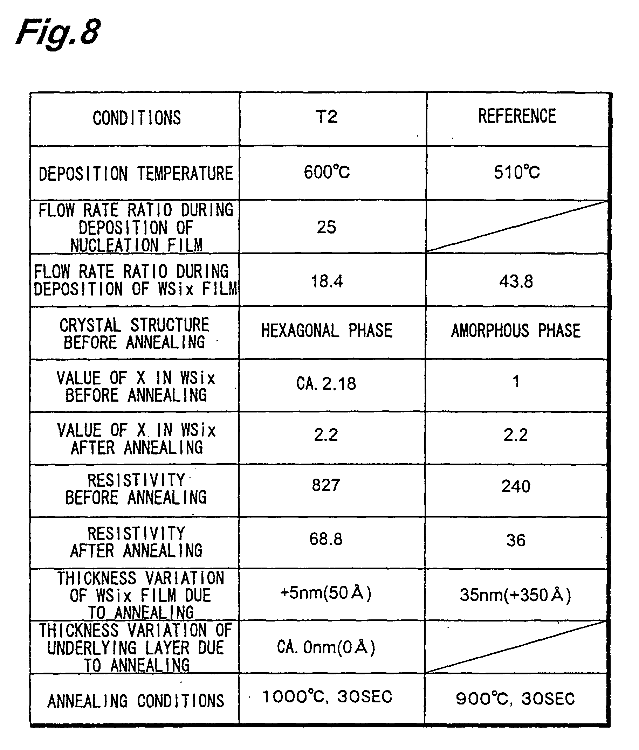

Fig. 8 shows data under the conditions T2 according to the present embodiment, and the comparative data under the reference conditions R.

Regarding the deposition temperature (stage temperature):
The deposition temperature is 600°C in the conditions T2, whereas the deposition temperature is 510°C in the reference conditions R for comparative data. From the data presented above, the inventor thought that it was preferable to carry out the formation of the tungsten silicide film at the high temperatures as disclosed in the present specification.

Regarding the flow rate ratio in the deposition:
The flow rate ratio means a ratio of flow rates of DSC gas/WF₆ gas. In the conditions T2, the flow rate ratio is 18.4, whereas the flow rate ratio is 43.8 in the reference conditions R for comparative data. The inventor considered that it was preferable to form the tungsten silicide film at the relatively low flow rate ratio as disclosed in the present specification.

Regarding the crystal structure before the annealing treatment:
The main crystal phase is the hexagonal phase in the conditions T2, whereas the amorphous phase is formed in the reference conditions R for comparative data. The inventor considered that the tungsten silicide film preferably included the hexagonal crystal phase.

Regarding the value of x in the WSix film before the annealing treatment:
In the conditions T2 the value x = 2.18 approximately, while in the reference conditions R for comparative data the value x = 1. The inventor considered that it was preferable to form the CVD deposited film at the value x=(2.2 ± 0.3) close to a value of x in the film formed finally. The value of x after the annealing is approximately 2.2 in both the conditions T2 and the reference conditions R. The conditions T2 are thus effective for suppressing the thickness variation between before and after the annealing treatment.

Regarding the resistivity:
In the conditions T2 the resistivity before the annealing treatment is 825 *µ*Ωcm, while the resistivity after the annealing is 68.8 *µ*Ωcm. The annealing treatment decreases the resistivity to below about one tenth. On the other hand, in the reference conditions R for comparative data, the resistivity is 240 *µ*Ωcm before the annealing treatment and the resistivity is 36 *µ*Ωcm after the annealing treatment. In the present specification, the data demonstrates the resistivity is larger than that of the comparative data, but even the resistivity in the data is satisfactorily applicable in practice.

Regarding the thickness variation:
In the conditions T2, the tungsten silicide film exhibits the thickness increase of about 5 nm (50Å), whereas the underlying polysilicon film exhibits the thickness decrease of about 0 nm (0Å). On the other hand, in the reference conditions R for comparative data, the tungsten silicide film demonstrates the thickness increase of about 35 nm (350Å). Accordingly, the data in the conditions T2 of the present specification is overwhelmingly superior to the comparative data.

Regarding the annealing conditions:
In the conditions T2, the deposited film is annealed at 1000°C for 30 seconds. In the reference conditions R for comparative data, the deposited film is annealed at 900°C for 30 seconds. The experiments indicate that increase in the annealing temperature yields the WSi film having lower resistivity.

As described above, the deposited film is particularly superior in the thickness variation in the conditions T2 according to the present embodiment. This makes it feasible to avoid the problem of delamination of the polycide film, even with further progress in scaling-down semiconductor integrated circuits. In addition, the resistivity of the tungsten silicide film has also been lowered to the practically applicable level.

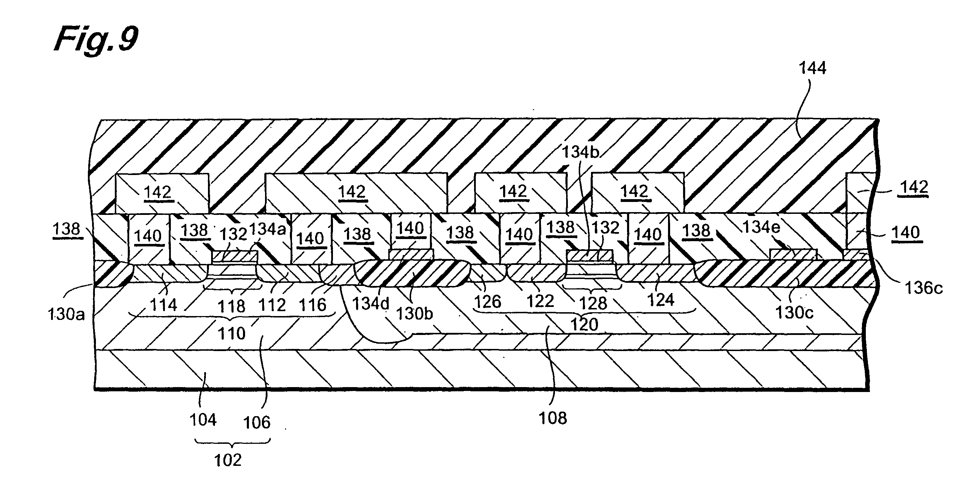

Subsequently, a method of fabricating metal-insulator-semiconductor (MIS) transistors will be described. Fig. 9 is a cross-sectional view showing an embodiment of the method of fabricating metal-oxide-semiconductor (MOS) transistors. N-channel MOS device 110 and p-channel MOS device 120 will be formed on a substrate 102. The substrate 102 has a p-type epitaxial layer 106 on a p-type high-concentration wafer 104.

The n-channel device 110 is formed on the p-type epitaxial layer 106. For forming a p-channel device 120, an n-well 108 is formed so as to include a predetermined region on the substrate. Device isolation film 130a, 130b, 130c are formed in order to isolate the n-channel device 110 and p-channel device 120 from each other. The device isolation film 130a to 130c surrounds individual device-forming regions. The n-channel device 110 is located between the device isolation film 130a, 130b. The p-channel device 110 is located between the device isolation film 130b, 130c.

A gate insulator film 132 is formed. The gate insulators are formed in the respective device-forming regions in the thermal oxidation method. Gate electrodes 134a to 134e having the polycide structure are formed on the gate insulators 132. For obtaining the gate electrodes 134a to 134e, a phosphorus-doped polysilicon film is formed on the gate insulators 132 and then a tungsten silicide film is formed thereon. The deposition method of the embodiment as described previously can be applied to the formation of this tungsten silicide layer. After depositing the tungsten silicide layer, a resist layer is formed using the photolithographic method. The tungsten silicide film and the polysilicon layer are etched in a dry etching method using this resist layer as a mask, thereby forming the gate electrodes 134a to 134e.

Particularly, for controlling the transistor properties such as the threshold, impurities are introduced into regions 118, 128 immediately below the gate electrodes 134a, 130b in an ion implantation method. After the formation of the gate electrodes 134a, 134b, n-type source diffusion region 112 and n-type drain diffusion region 114 are formed in a self-aligning manner with reference to the gate electrode 134a. P-type source diffusion region 122 and p-type drain diffusion region 124 are formed in a self-aligning manner with reference to the gate electrode 134b. N-type diffusion layer 116 is a contact diffusion layer to the p-type epitaxial layer 106, and p-type diffusion layer 126 is a contact diffusion layer to the n-well 108.

Next, a silicon oxide film 138 such as a BPSG film is formed. The silicon oxide film 138 works as an interlayer dielectric film. The silicon oxide film 138 is formed, for example, in the thickness of 800 nm using the CVD method. Thereafter, contact holes are formed in the silicon oxide film 138 so as to reach the diffusion layers and gate electrodes on the surface of the substrate 102. These contact holes are formed, for example, by the photolithographic process and dry etching process. Buried plugs 140, such as tungsten plugs (W-plugs), are formed in the contact holes. Prior to the burying step of tungsten, TiW films can be formed on the bottom and side surfaces of the contact holes if necessary. The TiW films and W-plugs are formed, for example, in the sputtering method and in the CVD method, respectively. After the formation of the buried plugs 140, the silicon oxide film 138 and buried plugs 140 are planarized in the CMP method.

A wiring layer 142 is formed on the planarized silicon oxide film 138. The wiring layer 142 can comprise, for example, three layers of TiW film, Cu film, and TiW film. For example, the TiW film is made by sputtering and the Cu film is made by electroplating. Then, a predetermined wiring pattern is formed in the photolithographic method and the dry etching method. The wiring layer 142 has the thickness of 500 nm, for example. A passivation film 144, such as a plasma-nitrided film, is formed on the wiring layer 142.

The embodiment as described above realizes the polycide gates meeting both the increasing needs for lower resistance and for smaller thickness change with progress in scaling-down for higher integration. Therefore, the scaling-down can be advanced without employing polymetal gates for the gate electrodes. Accordingly, there is no need for bearing the cost for facilities and techniques necessary for realizing the polymetal gates.

With the tungsten silicide film as described in the present embodiments, it is feasible to suppress the thickness decrease of the underlying layer and the thickness increase of the WSix film, thereby preventing the delamination.

Having been illustrated and described the principle of the present invention in the preferred embodiments, it is apparent to those skilled in the art that the present invention can be changed in arrangements and details without departing from the principle thereof. For example, the description heretofore was given as to the gate electrodes of the MIS devices, but it is also possible to use as wirings the conductive layer formed in the same step as the gate electrodes. Further, the underlying polysilicon layer may be doped with boron. Accordingly, the inventor claims all modifications and changes coming from the scope of the claims and the scope of the spirit of the invention.

### Industrial Applicability

As described above, in the method of forming the tungsten silicide film according to the present invention, the CVD method is adopted using the source gases including WF₆ and *Si*_{*2*}*H*_{*2*}*Cl*_{*2*}. The deposited film, containing silicon and tungsten as main constitutive elements, is formed in this CVD method. This deposited film can mainly include the hexagonal crystal phase, or is formed at the temperature over the stage temperature of 550°C. Then, this deposited film is thermally treated in the ammonia atmosphere.

This step ensures the composition defined by the formation of the hexagonal crystal phase, i.e., the value of x in WSiₓ, so that change the thickness difference of the tungsten silicide film is reduced between before and after the thermal treatment.

This tungsten silicide film can be applied to the gate electrodes of the MIS transistors. This application reduces the occurrence of troubles, such as delamination of the gate electrode, and allows the fabrication of the MIS transistors having gate electrodes of low resistance.

Therefore, the invention provides the method of forming the tungsten silicide film exhibiting small change in the thickness of the WSi film between before and after the thermal treatment, and the method of fabricating the metal-insulator-semiconductor transistor.

## Claims

1. A method of forming a tungsten silicide film on a silicon semiconductor region provided on a principal surface of a substrate, said method comprising the steps of:
forming a deposition film, containing silicon and tungsten as main constitutive elements and containing the hexagonal phase, in a CVD method using WF₆ and Si₂H₂Cl₂; and
carrying out a thermal treatment of said deposition film in an ammonia atmosphere to form a tungsten silicide film.

2. A method of forming a tungsten silicide film on a silicon semiconductor region provided on a principal surface of a substrate, said method comprising the steps of:
forming a deposition film, containing silicon and tungsten as main constitutive elements, at a stage temperature over 550°C in a CVD method using WF₆ and Si₂H₂Cl₂; and
carrying out a thermal treatment of said deposition film in an ammonia atmosphere to form a tungsten silicide film.

3. The method according to Claim 2, wherein said stage temperature is not less than 600°C.

4. The method according to Claim 2 or 3, wherein said stage temperature is not more than 800°C.

5. The method according to any one of Claims 2 to 4, wherein said deposition film contains the hexagonal crystal phase.

6. The method according to any one of Claims 1 to 5, further comprising the step of, prior to the formation of said deposition film, treating said silicon semiconductor region with a solution containing hydrofluoric acid.

7. The method according to any one of Claims 1 to 6, wherein said silicon semiconductor region includes a region comprising at least one of a polysilicon layer, an amorphous silicon layer, and a silicon layer containing germanium.

8. The method according to any one of Claims 1 to 7, wherein said thermal treatment is carried out in a rapid thermal annealing apparatus.

9. The method according to any one of Claims 1 to 8, wherein said silicon semiconductor region contains at least one element of phosphorus and boron.

10. A method of fabricating a metal-insulator-semiconductor transistor, said method comprising the steps of:
forming a gate insulator on a principal surface of a substrate;
forming a polysilicon film on said gate insulator;
providing a CVD chamber with said substrate having said polysilicon film thereon;
forming a deposition film, containing silicon and tungsten as main constitutive elements, at a stage temperature over 550°C in a CVD method using WF₆ and *Si*_{*2*}*H*_{*2*}*Cl*_{*2*};
providing a thermal treatment chamber with said substrate having said deposited film thereon;
providing said deposition film with a thermal treatment in an ammonia atmosphere in said thermal treatment chamber to form a tungsten silicide film; and
forming a gate electrode from said polysilicon film and said tungsten silicide film subjected to said thermal treatment.

11. The method according to Claim 10, wherein said stage temperature is not less than 600°C.

12. The method according to Claim 10 or 11, wherein said stage temperature is not more than 800°C.

13. The method according to any one of Claims 10 to 12, wherein said deposition film contains the hexagonal crystal phase.

14. The method according to any one of Claims 10 to 13, wherein said thermal treatment is carried out in a rapid thermal annealing apparatus.

15. The method according to any one of Claims 10 to 14, wherein said silicon layer contains at least one element of phosphorus and boron.

16. The method according to any one of Claims 10 to 15, wherein said silicon layer contains at least one of a polysilicon layer, an amorphous silicon layer, and a silicon layer containing germanium.
